# EUROPÄISCHE PATENTSCHRIFT

(11) **EP 2 368 846 B1**
(45) Veröffentlichungstag und Bekanntmachung des Hinweises auf die Patenterteilung: **14.11.2012**
(21) Anmeldenummer: 11152861.8
(22) Anmeldetag: 01.02.2011
(51) Int. Cl.: C01B 33/035, C23C 16/24, C23C 16/44

(54) **Verfahren zur Herstellung von rissfreien polykristallinen Siliciumstäben**
Method for producing crack-free polycrystalline silicon rods
Procédé de fabrication de tiges de silicium poly-cristallines sans fissure

(30) Priorität: 19.03.2010 DE 102010003068
(43) Veröffentlichungstag der Anmeldung: 28.09.2011
(73) Patentinhaber: Wacker Chemie AG, 81737 München (DE)
(72) Erfinder: Kraus, Heinz, 84367, Zeilarn (DE)
(74) Vertreter: Killinger, Andreas

(56) Entgegenhaltungen:
- WO-A1-2010/133386
- DE-A1- 19 741 465
- DE-A1-102007 023 041

## Beschreibung

Die Erfindung betrifft ein Verfahren zur Herstellung von polykristallinen Siliciumstäben mit großem Durchmesser, bei dem zur Vermeidung von Rissbildung und Abplatzungen im Siliciumstab Scheiben aus einem Material mit niedrigerem spezifischen elektrischen Widerstand als das polykristalline Silicium eingelegt werden.

Bei der Abscheidung von Polysilicium nach dem Siemens Prozess wird hochreines elementares Silicium aus der Gasphase an der Oberfläche von Siliciumstäben abgeschieden. Dabei wird in einem Abscheidereaktor an der Oberfläche eines auf 900 bis 1200 °C beheizten Silicium Dünnstabes aus einer Mischung von Wasserstoff und Halogensilanen oder einer wasserstoffhaltigen Siliciumverbindung elementares Silicium aus der Gasphase abgeschieden.
Die Siliciumstäbe werden dabei im Reaktor von speziellen Elektroden gehalten, die in der Regel aus hochreinem Elektrographit bestehen. Jeweils zwei Dünnstäbe mit unterschiedlicher Spannungspolung an den Elektrodenhalterungen sind am anderen Dünnstabende mit einer Brücke zu einem geschlossenen Stromkreis verbunden. Über die Elektroden und deren Elektrodenhalterungen wird elektrische Energie zur Beheizung der Dünnstäbe zugeführt. Über Einlassdüsen an der Bodenplatte des Abscheidereaktors wird eine Mischung von Wasserstoff und Halogensilanen zugefügt. Dabei zersetzen sich die Halogensilane an der Oberfläche der Dünnstäbe. Dabei wächst der Durchmesser der Dünnstäbe. Gleichzeitig wächst die Elektrode, beginned an ihrer Spitze, in den Stabfuß der Siliciumstäbe ein. Nach dem Erreichen eines gewünschten Solldurchmessers der Siliciumstäbe wird der Abscheideprozess beendet, die glühenden Siliciumstäbe abgekühlt und ausgebaut.

Eine besondere Bedeutung kommt hier dem Material und der Form der Elektroden zu. Sie dienen zum einen der Halterung der Dünnstäbe, der Übertragung des Stromflusses in den Siliciumstab, aber auch der Wärmeübertragung und auch als sicherer Stand des heranwachsenden Stabes im Reaktor. Da der Trend zu immer längeren und schwereren Stäbe geht und die Stabpaare, die inzwischen mehrere hundert Kilo schwer sein können, nur über die Elektroden im Reaktor verankert sind, ist gerade die Wahl der Form und der Materialbeschaffenheit sehr wichtig.
Elektroden nach dem Stand der Technik bestehen im unteren Teil aus einem zylindrischen Grundkörper und im oberen Teil aus einer Kegelspitze. An der Kegelspitze ist eine Bohrung zur Aufnahme des Dünnstabs angebracht. Das untere Ende der Elektrode wird dabei in eine metallische Elektrodenhalterung gesetzt, über die der Strom zugeführt wird. Solche Elektroden sind allgemein bekannt und werden beispielsweise in der US-5,284,640 zur Siliciumabscheidung verwendet.

Als Werkstoff für die Elektroden wird hauptsächlich Graphit verwendet, da Graphit in sehr hoher Reinheit zur Verfügung steht und bei Abscheidebedingungen chemisch inert ist. Weiterhin hat Graphit einen sehr geringen spezifischen elektrischen Widerstand.

Nach dem Abscheideprozess werden die erhaltenen, U-förmigen Stabpaare aus Polysilicium elektroden- und brückenseitig abgelängt. Die erhaltenen Stäbe müssen an beiden Stabenden und über die gesamte Stablänge frei von Rissen und Absprüngen sein. Anschließend werden die so erhaltenen Stäbe zu Stabstücken abgelängt, wobei Kundenanforderungen wie Stablänge und Stabgewicht eingehalten werden müssen. Auch diese Stäbe müssen beidseitig und über die gesamte Stablänge frei von Rissen und Abplatzungen sein.

Nachteilig an allen aus dem Stand der Technik bekannten Elektroden ist, dass diese am Übergang zwischen Elektrode zum Siliciumstab, oder im Siliciumstab in der Nähe der Elektrode, mehr oder minder zur Rissbildung oder zur Abplatzung von Material neigen und somit den Siliciumstab instabil machen. Damit eine hohe Ausbeute an rissfreier Stablänge erhalten wird, sollen die elektroden- und brückenseitigen Stabenden der erhaltenen U-förmigen Stabpaare aus Polysilicium möglichst wenig und im Idealfall gar keine Risse und Abplatzungen aufweisen. Stabbereiche mit Rissen bedeuten einen hohen Aufwand beim Ablängen der Stäbe, da die Stabenden scheibenweise bis zum Erreichen der Rissfreiheit abgelängt werden.
Länge, Durchmesser und Gewicht der bearbeiteten Polysiliciumstäbe sind Bestandteil der Kundenspezifikation. Die Kundenanforderungen verschieben sich immer weiter zu langen und dicken Stäben. Andererseits nehmen Risse und Absprünge mit steigendem Abscheidedurchrnesser bei der Herstellung zu. Eine Methode zur Rissvermeidung birgt somit hohes wirtschaftliches Potential.

Zur Vermeidung von Rissen und Abplatzungen in Stäben aus polykristallinem Silicium gibt es bereits verschiedene Veröffentlichungen.

US-6,676,916 beschreibt beispielsweise ein Verfahren bei dem in die Dünnstäbe unterhalb der Brücke kleine Fehlstellen, wie Bohrungen oder Kerben, angebracht werden. Als weitere Möglichkeiten werden Verdickungen des Dünnstabs durch Stauchen oder Einschnürungen des Leitungsquerschnitts erwähnt. An diesen Störstellen sollen sich bei der Abscheidung durch gestörtes kristallines Wachstum eine Spaltebene bilden. Bei thermischen Verspannungen sollen diese Ebenen dann als bevorzugte Bruchstellen wirken.

Dicke und rissfreie Polysiliciumstangen werden in Produktionsprozessen, wie beispielsweise das Zonenziehen, das Nachchargieren von Czochralski-Prozessen oder das Schneiden von neuen Dünnstäben eingesetzt. Diese Prozesse setzen eine glatte Staboberfläche und einen kompakten Stabquerschnitt ohne Fehlstellen und ohne Bereiche mit unterschiedlicher Kristallstruktur im Stab voraus. Deshalb ist ein gleichmäßiger Kristallaufbau der Polysiliciumstangen während des Abscheideprozesses notwendig. Kleine Fehlstellen am Dünnstab, wie sie in US-6,676,916 vorgeschlagen werden, verwachsen bei solchen Abscheideprozessen bereits bei dünnem Stabdurchmesser vollständig. Dadurch wirkt der Bereich bei dicken Stäben nicht mehr als bevorzugte Bruchstelle.

Aus JP-63074909 ist ein Verfahren zur Vermeidung von Rissen und Abplatzungen bekannt, bei dem die Siliciumstäbe mit hochfrequentem Wechselstrom beheizt werden. Mit hochfrequentem Wechselstrom wird die Stromdichte nach dem sogenannten Skin Effekt zum Stabrand hin verschoben. Die Temperaturdifferenz zwischen Stabmitte und Staboberfläche kann dadurch klein gehalten werden. Je höher die Frequenz, desto stärker die Verschiebung der Stromdichte zum Stabrand. Zur Erreichung eines nennenswerten Effekts sind Frequenzen > 100kHz notwendig. Nachteilig an diesem Verfahren ist es, dass in Verbindung mit den hohen Stromstärken und Spannungen, die zur Beheizung der Stäbe notwendig sind, eine sehr kostenaufwendige Abschirmung von Stromversorgung und Abscheideanlage notwendig wird. Unter praktischen und wirtschaftlichen Bedingungen ist dieses Verfahren daher nur schwer durchführbar.

Mit keinem aus dem Stand der Technik bekanntem Verfahren konnten bei den heute üblichen großen Stabdurchmessern wirtschaftliche und einfache Verfahren zur Verfügung gestellt werden, die eine Rissbildung und das Auftreten von Abplatzungen im Bereich des Überganges zum Stabfuß und zur Stabbrücke verhindern.

Es bestand somit die Aufgabe ein einfaches Verfahren zur Herstellung von Siliziumstäben mit großem Durchmesser bereitzustellen, das eine Reduzierung von Rissen und Absprüngen sowohl an den brückenseitigen als auch an den elektrodenseitigen Stabenden bewirkt und somit die rissfreie Stablänge nach dem Ablängen der Stabenden erhöht.

Überraschenderweise wurde nun gefunden, dass durch den Einbau von Scheiben oberhalb der verwendeten Elektroden und unterhalb der Brücke zwischen den beiden Stäben eines Stabpaares, die aus einem Material bestehen, das bei Abscheidebedingungen einen niedrigeren spezifischen elektrischen Widerstand als das polykristalline Silicium besitzt, die riss- und abplatzungsfreie Stablänge signifikant erhöht werden kann.

Gegenstand der Erfindung ist ein Verfahren gemäß Anspruch 1 und polykristalline Silicium stäbe gemäß Anspruch 14.

Durch den erfindungsgemäßen Einsatz der Scheiben konnte eine Vergleichmäßigung der Stromdichte in den Stäben erreicht werden. Dazu werden Scheiben aus einem Werkstoff mit deutlich niedrigerem ohmschen Widerstand als von Silicium oberhalb der Elektroden und unterhalb der Brücke der Stäbe fixiert. Es ist auch möglich, die Scheiben nur elektrodenseitig oder nur brückenseitig einzusetzen. In diesem Fall reduziert sich die positive Wirkung der Scheiben bezüglich Vermeidung von Rissen und Absprüngen nur auf das Stabende, an dem die Scheibe eingelegt wurde.

Die Scheiben können in einem Winkel von 45 bis 90° zur Stabachse eingesetzt werden, vorzugsweise 60 bis 90° und besonders bevorzugt 90° zur Stabachse.

Die Scheiben haben je nach gewünschtem Stabdurchmesser einen Durchmesser zwischen 30 und 250 mm, bevorzugt 50 bis 220 mm und besonders bevorzugt 90 bis 200 mm. Idealerweise entspricht der Scheibendurchmesser für die brückenseitige Scheiben dem gewünschten Stabdurchmesser. Der elektrodenseitige Scheibendurchmesser kann etwas kleiner sein, sofern die Scheibe auf der Elektrodenspitze aufliegt. Hier liegt der ideale Scheibendurchmesser bei ca 80% vom mittleren Stabdurchmesser.

Die Scheibendicke liegt zwischen 0,5 und 100 mm, bevorzugt zwischen 1 und 20 mm, besonders bevorzugt zwischen 2 und 10 mm.

Als Werkstoff für die Scheiben eignen sich alle hochschmelzenden, gegen heißes Silicium im Temperaturbereich bis zu 1300°C beständigen Materialien, die bei Abscheidebedingungen einen niedrigeren spezifischen elektrischen Widerstand haben als das polykristalline Silicium, d.h. der spezifische Widerstand des Scheibenmaterials ist im Temperaturbereich zwischen 900 und 1200 °C kleiner 100 µOhm*m. Dies entspricht im Falle von Graphit als Scheibenmaterial bei 20 °C einem spezifischem elektrischen Widerstand kleiner 130 µOhm*m. Geeignete Materialien sind hochschmelzende Metalle wie Wolfram und Tantal oder Graphit.
Weitere geeignete Werkstoffe sind dotiertes polykristallines oder einkristallines Silicium, Siliciumcarbid oder CFC (Carbon Fiber reinforced Carbon) Verbundwerkstoffe, bevorzugt einkristallines Silicium. Aus Reinheitsgründen wird hochreiner Elektrographit besonders bevorzugt. Eine Beschichtung der Graphitteile mit Silicium, Siliciumcarbid, Pyrokohlenstoff, Siliciumnitrid, Glaskohlenstoff oder Silicene, d.h. Nano Silicium, ist ebenfalls möglich. Bevorzugt wird dabei eine Schichtdicke kleiner 100 µm.

Der arithmetische Mittelrauwert der Oberflächenrauigkeit Ra der verwendeten Scheibe, gemessen nach DIN EN ISO 4287, liegt zwischen 1 und 20 µm, bevorzugt zwischen 1 und 15 µm, besonders bevorzugt zwischen 1 und 10 µm bei einer Gesamthöhe des Rauheitsprofils Rt zwischen 10 und 200 µm, bevorzugt zwischen 10 und 150 µm, besondes bevorzugt zwischen 10 und 100 µm und einer gemittelten Rautiefe Rz zwischen 8 und 160 µm, bevorzugt zwischen 8 und 120 µm, besonders bevorzugt zwischen 8 und 80 µm.

Für eine optimale Vermeidung thermischer Verspannungen muss der spezifische elektrische Widerstand der Scheiben bei Abscheidetemperatur - bei isotropen Werkstoffen insbesondere in Scheibenebene - deutlich kleiner sein als von hochreinem Silicium. Der spezifische Widerstand der Scheiben sollte bei 20°C, gemessen nach DIN 51911, kleiner 130 µOhm*m, bevorzugt kleiner 75 µOhm*m und besonders bevorzugt kleiner 30 µOhm*m sein.

Die Scheiben können in Verbindung mit allen aus dem Stand der Technik bekannten Elektroden verwendet werden. Diese Elektroden sind vorzugsweise aus Elektrographit, mit niedrigerem spezifischem elektrischem Widerstand als hochreinem Silicium. Die Form dieser Elektroden ist kegelförmig mit einer zentralen Spitze zum Siliciumstab hin, die den Dünnstab trägt.

Die optimale Position der elektrodenseitigen Scheibe ist am Stabfuß unmittelbar über der Elektrode. Bevorzugt wird die Scheibe in einem Abstand von 0 bis 1000 mm, gemessen von der Elektrodenspitze, eingesetzt. Besonders bevorzugt ist das Auflegen der Scheibe auf die Elektrodenspitze. Dazu kann in Scheibenmitte einfach eine kegelförmige Bohrung eingebracht werden, mit der die Scheibe auf die Elektrodenspitze passend aufgesteckt werden kann und durch die der Trägerstab (Dünnstab) in die Elektrode gesteckt wird. Die Scheibe kann auch bis zu einem Bereich von 20 mm unterhalb der Elektrodenspitze plaziert werden, wobei die positive Wirkung der Scheiben mit zunehmendem Abstand unterhalb der Elektrodenspitze abnimmt.
Aufgrund des niedrigeren spezifischen Widerstands der Scheibe erfolgt die Stromzufuhr in den Stabfuß nicht mehr zentral über die Elektrodenspitze in den Stabfuß, sondern vergleichmäßigt über den Scheibenquerschnitt. Der Temperaturgradient von Stabmitte zur Staboberfläche im Stabfuß ist dadurch deutlich niedriger.

Weiterhin wirken die Scheiben wie eine Sollbruchstelle, die verbliebene Restspannungen durch Bildung von konusförmigen Rissen an den Stäben im Bereich der Scheiben abbaut. Im Bereich bis 100 mm oberhalb und unterhalb der Scheiben treten beim Abkühlen noch konusförmige Risse auf, so dass die verbleibenden Stabenden eine leicht angespitzte Form haben.
Die Stäbe sind am Ende der konusförmigen Risse, ca. 100 mm oberhalb der elektrodenseitigen Scheiben und 100 mm unterhalb der brückenseitigen Scheiben bereits frei von Rissen und Absprüngen.

Eine Elektrode nach dem Stand der Technik, ergänzt mit der Form einer Scheibe, zusammen aus einem Stück ist ebenfalls möglich und hat die gleiche Wirkung. Die Herstellung in einem Stück ist jedoch wegen des im Vergleich zum Elektrodendurchmessers großen Scheibendurchmessers ungünstiger als die getrennte Herstellung einer Elektrode und einer Scheibe aus einzelnen Teilen.

Neben den Scheiben am Stabfuß kann optional auch eine Scheibe am oberen Ende des Stabes, am Übergang zur Brücke eines Stabpaares, eingesetzt werden. Bevorzugt wird die Scheibe 200 bis 1000 mm unterhalb der Brücke eingesetzt, bevorzugt 200 bis 800 mm und besonders bevorzugt 300 bis 600 mm, jeweils bezogen auf die Dünnstabbrücke.

Bevorzugt wird diese Scheibe im rechten Winkel zur Stabachse eingesetzt. Ein Winkel abweichend von 90° zur Stabachse ist möglich, reduziert aber die Wirkung der Scheibe.

Die Scheibe kann direkt in den Dünnstab eingesetzt werden oder auch mittels eines Adapters fixiert werden. Dazu haben die Scheiben in der Scheibenmitte bevorzugt eine zylindrische Bohrung. Die vertikale Position der Scheiben ist abhängig vom Enddurchmesser der Stäbe. Sie ist so zu wählen, dass die Scheibe nach Erreichen des gewünschten Stabdurchmessers noch unterhalb des Brückenbogens liegt. Die oberste Position, bei der die brückenseitige Scheibe noch im geraden Teil der Stabschenkel liegt, ist bei dünneren Stäben näher zur Brücke als bei dickeren Stäben. Tiefere und damit von der Brücke entferntere Positionen sind möglich, die später erzielte rissfreie Stablänge wird dabei aber verringert.

Unterhalb der Scheibe in Brückennähe ist die Stromdichte vergleichmäßigt und nimmt nur in geringem Maße aufgrund der spezifischen Wärmeleitfähigkeit und der Temperaturabhängigkeit des spezifischen elektrischen Widerstands von Silicium von der Staboberfläche zur Stabmitte in Form von konzentrischen Kreisen zu. Die Stäbe sind ca.
100 mm unterhalb der brückenseitigen Scheiben frei von Rissen und Absprüngen ablängbar.

Da die dünnen Trägerstäbe aufgrund der Gasströmung im Reaktor schwanken können, ist es sinnvoll, die brückenseitigen Scheiben von benachbarten Trägerstäben in geringfügig unterschiedlichen Höhen zu fixieren. Im Versuch haben sich dabei Höhenunterschiede zwischen 20 und 50 mm bewährt. Größere Höhenunterschiede sind möglich, verkürzen allerdings die nutzbare Stablänge der Stäbe mit der niedrigeren Scheibenposition. Dabei sind Scheiben von benachbarten Trägerstäben in unterschiedlichen Höhen positioniert. Auf diese Weise werden kurzzeitige Berührungen von Scheiben benachbarter Stabpaare durch schwankende Trägerstäbe verhindert. Ein Zusammenstoßen benachbarter Scheiben kann zu Bruch von Scheiben und Trägerstäben mit Ausfall der Abscheideanlage führen.

Die Fixierung der Scheiben erfolgt entweder durch einfaches Auflegen auf die Elektroden oder mittels geeigneter Adapter oder Hülsen. Einfache Adapter können beispielsweise längliche Verbindungskörper mit jeweils einem Hohlraum, z.B. einer Bohrung, an den Enden sein. Mit dem Adapter können zwei dünne Trägerstäbe zu einem längerem Trägerstab durch einfaches zusammenstecken verbunden werden. Der Adapter trägt zusätzlich eine Vorrichtung zur Aufnahme der Scheibe. Dies kann beispielsweise ein Rand oder Bund sein, auf dem die Scheibe aufliegt.

Als Werkstoff für Adapter eignen sich alle hochschmelzenden, gegen heißes Silicium im Temperaturbereich bis 1300°C beständigen Materialien, die im Temperaturbereich größer 900 °C elektrisch leitfähig sind. Geeignete Materialien sind hochschmelzende Metalle wie Wolfram und Tantal oder Graphit. Weitere geeignete Werkstoffe sind dotiertes polykristallines oder einkristallines Silicium, Siliciumcarbid oder CFC (Carbon Fiber reinforced Carbon) Verbundwerkstoffe, bevorzugt einkristallines Silicium. Aus Reinheitsgründen wird hochreiner Elektrographit besonders bevorzugt. Eine Beschichtung der Graphitteile mit Silicium, Siliciumcarbid, Pyrokohlenstoff, Siliciumnitrid, Glaskohlenstoff oder Silicene, d.h. Nano Silicium, ist ebenfalls möglich. Bevorzugt wird dabei eine Schichtdicke kleiner 100 µm.

Adapter und Scheibe können aus unterschiedlichen Materialien oder aus dem gleichen Material hergestellt sein. Bevorzugt wird für beide Teile hochreiner Elektrographit verwendet.
Adapter und Scheibe können aus 2 getrennten Teilen oder aus einem Teil bestehen. Die Funktion wird bei beiden Ausführungsformen nicht beeinträchtigt. Aufgrund des großen Scheibendurchmessers im Vergleich zum Adapterdurchmesser und der geringen Scheibendicke zur Adapterlänge werden aus wirtschaftlichen Gründen zwei separate Teile bevorzugt.

Der spezifische elektrische Widerstand des Adapters kann auch größer sein als der des Siliciums, auf jeden Fall muss der Adapter elektrisch leitfähig sein. Im Idealfall hat der Adapter einen spezifischen elektrischen Widerstand kleiner oder gleich dem von undotiertem polykristallinen Silicium.

Weitere zusätzliche Scheiben auf Positionen zwischen einer elektrodenseitigen und einer brückenseitigen Scheibe sind ebenfalls möglich. Bevorzugt werden diese an geplanten Schnittpositionen zum Ablängen der Stäbe auf die später geforderte Länge angebracht. Die zusätzlichen Scheiben sind jedoch nicht zwingend notwendig, da die Stäbe zwischen brückenseitiger und elektrodenseitiger Scheibe arm an thermischen Verspannungen sind. Sie erleichtern aber das spätere Ablängen.

Die Scheiben müssen bei Abscheidetemperatur einen spezifischen elektrischen Widerstand haben, der deutlich kleiner ist als der von Silicium. Aufgrund des im Vergleich zu Silicium niedrigen spezifischen elektrischen Widerstands der Scheiben stellt sich zwischen brückenseitiger und elektrodenseitiger Scheibe eine über dem Stabquerschnitt vergleichmäßigte Stromdichte in den Siliciumstäben ein, die unabhängig von der vertikalen Position (elektrodenseitig, Stabmitte, brückenseitig) am Stab ist.

Bei einer weiteren Ausführungsform der Erfindung können zusätzliche Scheiben als spätere Sollbruchstellen an beliebigen Stellen des U-förmigen Stabpaares, bevorzugt in der Brücke, eingearbeitet werden. Die Wirkung dieser Scheiben bezüglich Vermeidung von Rissen und thermischen Verspannungen beruht nicht auf einer Vergleichmäßigung der Stromdichte, sondern lediglich als Sollbruchstelle. Beim Abkühlen der Stäbe werden im Bereich der Scheiben thermische Verspannungen durch Rissbildung in unmittelbarer Scheibennähe abgebaut, so dass der verbleibende Stab weniger geschädigt wird. Die Positionierung der Scheiben erfolgt ebenfalls mit Adaptern unterhalb der Brücke oder in der Brücke.
Die brückenseitige Scheibe mit alleiniger Funktion als Sollbruchscheibe kann aus einem Material mit geringerer elektrischer Leitfähigkeit als Silicium sein. Der spezifische elektrische Widerstand muss dabei mindestens so groß sein, dass ein Stromfluß durch die Scheiben möglich ist.
Geeignete Materialien sind hochschmelzende Metalle wie Wolfram und Tantal, dotiertes oder undotiertes polykristallines oder einkristallines Silicium, Grafit, Siliciumcarbid, Siliciumnitrid, CFC Verbundwerkstoffe, bevorzugt undotiertes einkristallines oder polykristallines Silicium. Eine Beschichtung der Graphitteile mit Silicium, Siliciumcarbid, Pyrokohlenstoff, Siliciumnitrid, Glaskohlenstoff oder Silicene, d.h. Nano Silicium, ist ebenfalls möglich. Bevorzugt wird dabei eine Schichtdicke kleiner 100 µm.

In einer Ausführungsform der Erfindung wird mindestens eine Scheibe in der Brücke eingesetzt. Dies kann mittels der bereits beschriebenen Adapter geschehen, oder auch einfach durch das Einhängen in eine Nut quer zur Brücke um das seitliche Verrutschen der Scheibe auf der Brücke zu verhindern. Die Scheibe kann, bezogen auf ihren Mittelpunkt, sowohl zentrisch als auch exzentrisch in die Brücke eingesetzt werden. Die Bohrung der Scheibe sollte in dieser Ausführungsform im Bereich zwischen Mittelpunkt der Scheibe und 0,8x Scheibenradius liegen, bevorzugt im Bereich zwischen 0,2x Scheibenradius und 0,6x Scheibenradius, besonders bevorzugt zwischen 0,2x Scheibenradius und 0,4x Scheibenradius.

Die Bohrung ist gerade so groß, dass die Brücke durch die Scheibe gesteckt werden kann. Im einfachsten Fall ist die Bohrung kreisförmig oder in Form einer Ellipse, idealerweise entspricht sie in Größe und Form dem Querschnitt der Brücke. Die Scheiben haben je nach gewünschtem Stabdurchmesser einen Durchmesser zwischen 30 und 250 mm, bevorzugt 50 bis 220 mm, besonders bevorzugt 90 bis 200 mm. Idealerweise entspricht der Scheibendurchmesser für die brückenseitige Scheiben dem gewünschten Stabdurchmesser.

Da die Scheiben in der Brücke keine besondere elektrische Funktion haben, können die Scheiben eine sehr geringe Dicke besitzen. Diese ist im Bereich von 0,5 bis 10 mm, bevorzugt 1 bis 5 mm und besonders bevorzugt 1 bis 3 mm.

Bei Verwendung von elektrodenseitigen und brückenseitigen Scheiben können bei einer Trägerstablänge von 3000 mm nach dem Ablängen polykristalline Siliciumstäbe mit einer riss- und absprungfreien Länge von größer 1400 mm, bevorzugt größer 1850 mm und besonders bevorzugt größer 2000 mm erhalten werden. Mit dem erfindungsgemäßen Verfahren können riss- und absprungfreie polykristalline Siliciumstäbe hergestellt werden mit einem Durchmesser zwischen 130 und 250 mm, bevorzugt zwischen 160 und 220 mm, besonders bevorzugt zwischen 180 und 220 mm.

Die erfindungsgemäß hergestellten, polykristallinen Siliciumstäbe können zur Produktion von monokristallinem Silicium mittels Floating-Zone Verfahren (FZ) verwendet werden.
Sie haben hierbei die Eigenschaft, dass während des Ziehprozesses keine zusätzlichen Abplatzungen auftreten, die unweigerlich zum Ende des Ziehprozesses führen würden und so die FZ Ausbeute drastisch reduzieren würde. Ferner reduziert die Verwendung der erfindungsgemäß hergestellten Stäbe die Wahrscheinlichkeit für Versetzungen im FZ Verfahren. Die Stäbe können in einem Ziehdurchgang versetzungsfrei gezogen werden. Weiterhin sind die Polysiliciumstäbe ohne Absprünge in den Tiegel für den CZ Ziehprozess, zur Erhöhung des Füllgrads der Tiegel, einschmelzbar. Ein weiterer Anwendungsfall sind riss-und absprungfreie kurze polykristalline Siliciumstäbe für eine dichte Befüllung des Tiegels beim CZ Ziehprozess in Verbindung mit Poly Chips unterschiedlicher Bruchgröße für die Zwischenräume der Stabstücke.

Anhand der folgenden Beispiele soll die Erfindung näher erläutert werden.

In einem Abscheidereaktor wurden polykristalline Siliciumstäbe nach dem Siemens Verfahren aus der Gasphase abgeschieden. Es wurden Graphiteelektroden nach dem Stand der Technik (Form siehe Patent US-5,593,465), d.h. mit länglicher Form, am oberen Ende mit einer kegelförmigen Spitze, montiert. Die Graphitelektrode hat an der Spitze in Längsrichtung eine Bohrung, in die ein dünner Trägerstab gesteckt wurde. Jeweils 2 benachbarte Träberstäbe werden am oberen Ende mit einem dünnen Trägerstab U-förmig zu einer Brücke verbunden. Die beiden Enden der Elektrodenhalterung ausserhalb des Abscheidereaktors wurden mit einer elektrischen Spannungsquelle zu einem geschlossenen Stromkreis verbunden. Durch direkten Stromdurchfluß wurden die Trägerstäbe elektrisch auf 900 bis 1200 °C beheizt. Während des Abscheideprozesses wurde ein Feed bestehend aus einer oder mehreren chlorhaltigen Silanverbindungen der Formel SiHₙCl₄₋ₙ (mit n = 0 .. 4) und Wasserstoff als Trägergas zugegeben. An der Oberfläche der Dünnstäbe zersetzt sich die halogenhaltige Silanverbindung, wobei polykristallines Silicium auf diesen aufwächst. Nach Erreichen des gewünschten Durchmessers zwischen 130 und 220 mm wurde die Reaktion beendet, die Stäbe abgekühlt und aus dem Abscheidereaktor ausgebaut.

### Beispiel 1:

Auf die Spitze der Graphitelektroden wurde jeweils eine Scheibe aus hochreinem Elektrographit mit einer passenden, zentralen Bohrung aufgesteckt. Die Spitze der Graphitelektrode hat mit der Scheibenoberfläche bündig abgeschlossen. Die Scheibe hatte einen Durchmessser von 130 mm und eine Dicke von 4 mm. In die Graphitelektroden wurden Trägerstäbe mit einer Länge von 2500 mm und 2550 mm derart gesteckt, dass immer ein Stabpaar einen längeren und einen kürzeren Trägerstab enthielt und benachbarte Stäbe unterschiedliche Längen hatten. Auf die Enden der Trägerstäbe wurden Adapter und Hülsen zum Verbinden von zwei Trägerstäben zu einem längeren Trägerstab gesteckt. Die Adapter bestanden aus hochreinem Elektrographit. In das andere Adapterende wurden kürzere Trägerstäbe mit einer Länge von 500 mm und 450 mm derart gesteckt, dass alle Trägerstäbe eine Gesamtlänge von 3000 mm hatten. Die Adapter dienten gleichzeitig zur Fixierung von jeweils einer hochreinen Graphitscheibe unterhalb der Brücke. Die Scheibe wurden mittels einer mittigen Bohrung auf den Adapter gesteckt und aufgelegt. Die Scheiben auf den Adaptern hatten einen Durchmesser von 180 mm und eine Dicke von 4 mm. Elektroden- und brückenbseitige Scheibe bildeten mit dem Dünnstab einen Winkel von jeweils 90°. Die Scheiben hatten einen spez. elektrischen Widerstand, gemessen bei Raumtemperatur nach DIN 51911, von kleiner 30 µOhm*m. Auf die so eingebauten Trägerstäbe wurde polykristallines Silicium bis zum Erreichen eines Durchmessers von 180 mm abgeschieden. Die fertigen polykristallinen Siliciumstäbe waren zwischen elektroden- und brückenseitiger Scheibe mit nur geringen Schnittverlusten an beiden Enden frei von Rissen und Absprüngen ablängbar, so dass die fertig bearbeiteten Stäbe über ihre gesamte Länge frei von Rissen und Absprüngen waren. 90% der so hergestellten erfindungsgemäßen, polykristallinen Siliciumstäbe hatten eine Länge von größer 2100 mm, die restlichen Stäbe lagen zwischen 1900 mm und 2100 mm. Die Stäbe konnten später in einem Zug mit dem Zonenziehverfahren versetzungsfrei zu Einkristalle gezogen werden. Aufgrund des hohen Gewichtes der rissfreien polykristallinen Stäbe eigneten sie sich besonders für den Einsatz zum Ziehen von Einkristallen mit großem Durchmesser, hier 8 Zoll.

### Vergleichsbeispiel 1:

Es wurde analog zu Beispiel 1 vorgegangen. Eine Vergleichsgruppe von Stäben wurde aber mit 3000 mm langen Dünnstäben aus einem Stück, d.h. ohne obere Scheiben und ohne Adapter, ansonsten mit gleichen Parametern, abgeschieden. Es wurde nur die Scheibe auf den Elektroden verwendet.
Wegen verstärkter Rissbildung an den brückenseitigen Stabenden mussten die Stäbe bis zum Erreichen von riss- und absprungfreien Stäben brückenseitig stärker gekürzt werden, so dass nur 20% der bearbeiteten Stäbe länger als 2100 mm waren, während 70% der Stäbe eine Länge zwischen 1800 mm und 2100 mm hatten. Die restlichen Stäbe hatten nur eine Länge kleiner als 1800 mm. Die rissfreien Stäbe waren ebenfalls versetzungsfrei mit dem Zonenziehverfahren auf 8 Zoll ziehbar, jedoch wegen den geringeren Stablängen mit niedrigerer ziehausbeute und niedrigerer Anlagenausbringung.

### Vergleichsbeispiel 2:

Es wurde analog zu Vergleichsbeispiel 1 vorgegangen und zusätzlich wurden auch die elektrodenseitigen Scheiben weggelassen. Die Stabpaare hatten somit keine Scheiben und es wurde analog dem Stand der Technik abgeschieden. Zusätzlich zu den brückenseitigen Rissen waren die elektrodenseitigen Stabenden nun auch verstärkt rissig. Zu den brückenseitigen Schnittverlusten kamen nun auch verstärkt Schnittverluste am elektrodenseitigen Stabende beim Ablängen der Stäbe bis zum Erreichen von rissfreien Stäben. Es gab keine rissfreien Stäbe mit einer Länge größer als 1800 mm. 15% der erhaltenden Stäbe hatte eine Länge zwischen 1500 mm und 1800 mm. 55% der Stäbe lag im Bereich von 1200 mm bis 1500 mm und 14% lagen zwischen 1000 mm und 1200 mm. Die restlichen Stäbe waren wegen zu geringer rissfreier Stablänge für das Zonenziehverfahren nicht brauchbar. Die polykristallinen Siliciumstäbe waren auch hier versetzungsfrei mit dem Zonenziehprozess ziehbar. Aufgrund ihres geringen Gewichts eigneten sie sich jedoch nicht als Vorstäbe zum Ziehen von 8 Zoll Einkristallen, sondern nur für Einkristalle von 6 Zoll Durchmesser und kleiner.

### Beispiel 2:

Auf die Spitze der Graphitelektroden wurde jeweils eine Scheibe aus hochreinem Elektrographit mit einer passenden, zentralen Bohrung aufgesteckt. Die Spitze der Graphitelektrode hat mit der Scheibenoberfläche bündig abgeschlossen. Die Scheiben hatten jeweils einen Durchmessser von 120 mm und eine Dicke von 4 mm. Die Graphitelektroden wurden mit Trägerstäben mit einer Länge von 2400 mm bestückt. In die Brücke der Stabpaare wurde jeweils eine Scheiben aus polykristallinem Silicium eingehängt. Der Durchmesser der Scheibe in der Brücke hatte 150 mm bei einer Scheibendicke von 2 mm. Die Bohrung zum Einhängen der Scheibe in die Brücke war aussermittig mit einem Abstand vom Mittelpunkt von 0,3x Scheibenradius. Die Scheibe war mittels einer Kerbe in der Brücke gegen verrutschen gesichert. Auf die so eingebauten Trägerstäbe wurde polykristallines Silicium aus der Gasphases bis zum Erreichen eines Durchmessers von 160 mm abgeschieden.
Nach dem Ausbauen der Stabpaare aus der Abscheideanlage waren 80% der Stabpaare an der Scheibe in der Brücke gebrochen. Die brückenseitigen Stabenden hatten nur wenig Risse, so dass nach dem Ablängen der Brückenteile nur wenig zusätzlicher Verschnitt an den brückenseitigen Stabenden bis zum Erreichen von riss-und absprungfreien Stabenden angefallen ist. Die brückenseitigen Stabenden mussten inklusive Brücken um jeweils 300 bis 500 mm gekürzt werden. Die elektrodenseitigen Stabenden waren ab einer Länge von 100 mm bis 200 mm oberhalb der elektrodenseitigen Scheiben riss- und absprungfrei. Die riss- und absprungfreien Stablängen lagen somit zwischen 1700 mm und 2100 mm. Aus den rissfreien Stäben konnten pro Stab 8 bis 10 kurze Stabstücke zu 200 mm zum Befüllen des Quarztiegels für den Czochralski Ziehprozess abgelängt werden.

### Vergleichsbeispiel 3:

Es wurde analog zu Beispiel 2 vorgegangen. Jedoch wurde als Vergleichsgruppe ohne Scheibe in der Brücke abgeschieden. Am Ende des Abscheidevorgangs mussten die Stabpaare vor der Entnahme aus dem Reaktor an der Brücke getrennt werden. Dabei wurden Verspannungen freigesetzt und während des Ablängens Absprünge erzeugt. Die brückenseitigen Schnittverluste bis zum Erreichen eines brückenseitigen rissfreien Stabendes waren 400 bis 700 mm. Inklusive 100 bis 200 mm elektrodenseitigem Verschnitt betrug die rissfreie Stablänge dann 1500 bis 1800 mm pro Siliciumstab. Daraus konnten 7 bis 9 kurze Stabstücke zum Befüllen des Quarztiegels für den Czochralski Ziehprozess abgelängt werden.

### Vergleichsbeispiel 4:

Es wurde analog zu Vergleichsbeispiel 3 vorgegangen. Zusätzlich wurde auch auf die elektrodenseitige Grafitscheibe verzichtet und damit nach dem Stand der Technik gearbeitet. Die restlichen Prozessparameter blieben gleich. Zusätzlich zum erhöhten brückenseitigen Verschnitt, hervorgerufen durch das Ablängen der Brücke und des rissigen brückenseitigen Stabendes, gab es an den elektrodenseitigen Stabenden erhöhter Anfall von Verschnitt auf Grund von Rissen und Abplatzungen. Nach dem Ablängen bis zum Erreichen von riss- und absprungfreien Stäben hatten die Stäbe nur noch eine Länge von 1100 mm bis 1500 mm. Daraus konnten lediglich 5 bis 7 kurze Stabstücke zum Befüllen des Quarztiegels für den Czochralski Ziehprozess abgelängt werden.

## Patentansprüche

1. Verfahren zur Herstellung von polykristallinen Siliziumstäben durch Abscheidung aus der Gasphase an einem Dünnstab, **dadurch gekennzeichnet, dass** in einem Bereich von höchstens 20 mm unterhalb einer Elektrodenspitze bis unterhalb der Brücke eines Stabpaares eine oder mehrere Scheiben eingelegt werden, die aus einem Material bestehen, das bei Abscheidebedingungen einen niedrigeren spezifischen elektrischen Widerstand als das polykristalline Silicium besitzt.

2. Verfahren nach Anspruch 1, **dadurch gekennzeichnet, dass** die verwendeten Scheiben einen Durchmesser von 30 bis 200 mm besitzen.

3. Verfahren nach Anspruch 1 bis 2, **dadurch gekennzeichnet, dass** der Durchmesser der verwendeten Scheiben dem Durchmesser des abgeschiedenen Stabes entspricht.

4. Verfahren nach Anspruch 1 bis 3, **dadurch gekennzeichnet, dass** der Scheibendurchmesser einer elektrodenseitig eingelegten Scheibe kleiner ist als der Durchmesser einer brückenseitigen Scheibe.

5. Verfahren nach Anspruch 1 bis 4, **dadurch gekennzeichnet, dass** die Scheibendicke zwischen 0,5 und 100 mm beträgt.

6. Verfahren nach Anspruch 1 bis 5, **dadurch gekennzeichnet, dass** die Scheiben in einem Winkel von 45 bis 90 Grad bezogen auf die Stabachse eingesetzt werden.

7. Verfahren nach Anspruch 1 bis 6, **dadurch gekennzeichnet, dass** die Scheiben aus Wolfram, Tantal, Graphit, Silicium, Siliciumcarbid, Siliciumnitrid oder Carbon-Fiber-Reinforced-Carbon Verbundwerkstoffen sind.

8. Verfahren nach Anspruch 1 bis 7, **dadurch gekennzeichnet, dass** der spezifische Widerstand der Scheiben bei 20°C kleiner als 130 µOhm*m beträgt.

9. Verfahren nach Anspruch 1 bis 8, **dadurch gekennzeichnet, dass** der arithmetische Mittelrauwert der Oberflächenrauigkeit Ra der verwendeten Scheibe zwischen 1 und 20 µm liegt, bei einer Gesamthöhe des Rauheitsprofils Rt zwischen 10 und 200 µm und einer gemittelten Rautiefe Rz zwischen 8 und 160 µm.

10. Verfahren nach Anspruch 1 bis 9, **dadurch gekennzeichnet, dass** eine elektrodenseitige Scheibe in einem Abstand zwischen 0 und 1000 mm oberhalb der Elektrodenspitze und eine brückenseitige Scheibe in einem Abstand von 200 mm bis 1000 mm unterhalb der Brücke eingesetzt werden.

11. Verfahren nach Anspruch 10, **dadurch gekennzeichnet, dass** die elektrodenseitige Scheibe direkt auf die Elektrodenspitze aufgelegt wird.

12. Verfahren nach Anspruch 1 bis 11, **dadurch gekennzeichnet, dass** die Scheiben mittels Adapter an den Dünnstäben befestigt werden.

13. Verfahren nach Anspruch 1 bis 12, **dadurch gekennzeichnet, dass** zusätzlich eine oder mehrere Scheiben in die Brücke der Stabpaare eingesetzt werden.

14. Polykristalliner Siliciumstab mit einem Durchmesser von größer oder gleich 130 mm und einer Länge von größer oder gleich 1900 mm, **dadurch gekennzeichnet, dass** dieser auf seiner gesamten Länge frei von Rissen und Abplatzungen ist.

15. Polykristalliner Siliciumstab nach Anspruch 14, mit einer Länge von größer als 2100 mm, der auf seiner gesamten Länge frei von Rissen und Abplatzungen ist.

16. Verwendung eines polykristallinen Stabes nach Anspruch 14 oder nach Anspruch 15 zum Zonenziehen (Floating-Zone Verfahren).

## Claims

1. Method for producing polycrystalline silicon rods by deposition from the gas phase on a thin rod, **characterized in that** one or a plurality of disks consisting of a material having a lower electrical resistivity than the polycrystalline silicon under deposition conditions are introduced in a range of at most 20 mm below an electrode tip to below the bridge of a rod pair.

2. Method according to Claim 1, **characterized in that** the disks used have a diameter of 30 to 200 mm.

3. Method according to Claims 1 to 2, **characterized in that** the diameter of the disks used corresponds to the diameter of the deposited rod.

4. Method according to Claims 1 to 3, **characterized in that** the disk diameter of a disk introduced on the electrode side is less than the diameter of a disk on the bridge side.

5. Method according to Claims 1 to 4, **characterized in that** the disk thickness is between 0.5 and 100 mm.

6. Method according to Claims 1 to 5, **characterized in that** the disks are inserted at an angle of 45 to 90 degrees relative to the rod axis.

7. Method according to Claims 1 to 6, **characterized in that** the disks are composed of tungsten, tantalum, graphite, silicon, silicon carbide, silicon nitride or carbon fiber reinforced carbon composite materials.

8. Method according to Claims 1 to 7, **characterized in that** the resistivity of the disks at 20°C is less than 130 µohm*m.

9. Method according to Claims 1 to 8, **characterized in that** the arithmetic mean roughness value of the surface roughness Ra of the disk used is between 1 and 20 µm, given a total height of the roughness profile Rt of between 10 and 200 µm and an averaged roughness depth Rz of between 8 and 160 µm.

10. Method according to Claims 1 to 9, **characterized in that** an electrode-side disk is inserted at a distance of between 0 and 1000 mm above the electrode tip and a bridge-side disk is inserted at a distance of 200 mm to 1000 mm below the bridge.

11. Method according to Claim 10, **characterized in that** the electrode-side disk is placed directly onto the electrode tip.

12. Method according to Claims 1 to 11, **characterized in that** the disks are fixed to the thin rods by means of adapters.

13. Method according to Claims 1 to 12, **characterized in that** one or a plurality of disks are additionally inserted into the bridge of the rod pairs.

14. Polycrystalline silicon rod having a diameter of greater than or equal to 130 mm and a length of greater than or equal to 1900 mm, **characterized in that** it is free of cracks and chipping over its entire length.

15. Polycrystalline silicon rod according to Claim 14, having a length of greater than 2100 mm, which is free of cracks and chipping over its entire length.

16. Use of a polycrystalline rod according to Claim 14 or according to Claim 15 for the floating zone method.

## Revendications

1. Procédé pour la fabrication de tiges de silicium polycristallines par séparation à partir de la phase de gaz sur une tige mince, **caractérisé en ce que** dans une zone d'au maximum 20 mm en dessous d'une pointe d'électrode jusqu'en dessous du pont d'une paire de tiges, une ou plusieurs plaquettes sont insérées, lesquelles se composent d'un matériau qui possède, dans des conditions de séparation, une résistance électrique spécifique plus faible que le silicium polycristallin.

2. Procédé selon la revendication 1, **caractérisé en ce que** les plaquettes utilisées possèdent un diamètre allant de 30 à 200 mm.

3. Procédé selon les revendications 1 et 2, **caractérisé en ce que** le diamètre des plaquettes utilisées correspond au diamètre de la tige séparée.

4. Procédé selon les revendications 1 à 3, **caractérisé en ce que** le diamètre de plaquette d'une plaquette mise en place côté électrode est inférieur au diamètre d'une plaquette côté pont.

5. Procédé selon les revendications 1 à 4, **caractérisé en ce que** l'épaisseur de plaquette est comprise entre 0,5 et 100 mm.

6. Procédé selon les revendications 1 à 5, **caractérisé en ce que** les plaquettes sont mises en place selon un angle de 45 à 90 degrés par rapport à l'axe de tige.

7. Procédé selon les revendications 1 à 6, **caractérisé en ce que** les plaquettes sont en tungstène, tantale, graphite, silicium, carbure de silicium, nitrure de silicium ou en matériaux composites en carbone renforcés par des fibres de carbone.

8. Procédé selon les revendications 1 à 7, **caractérisé en ce que** la résistance spécifique des plaquettes à 20°C est inférieure à 130 µOhm*m.

9. Procédé selon les revendications 1 à 8, **caractérisé en ce que** la valeur de rugosité moyenne arithmétique Ra de la plaquette utilisée est comprise entre 1 et 20 µm, avec une hauteur totale du profil de rugosité Rt comprise entre 10 et 200 µm et une profondeur de rugosité pondérée Rz comprise entre 8 et 160 µm.

10. Procédé selon les revendications 1 à 9, **caractérisé en ce qu'**une plaquette côté électrode est mise en place à une distance comprise entre 0 et 1000 mm au-dessus de la pointe d'électrode et **en ce qu'**une plaquette côté pont est mise en place à une distance comprise entre 200 mm et 1000 mm en dessous du pont.

11. Procédé selon la revendication 10, **caractérisé en ce que** la plaquette côté électrode est directement posée sur la pointe d'électrode.

12. Procédé selon les revendications 1 à 11,
**caractérisé en ce que** les plaquettes sont fixées à l'aide d'adaptateurs sur les tiges minces.

13. Procédé selon les revendications 1 à 12,
**caractérisé en ce qu'**une ou plusieurs plaquettes sont additionnellement mises en place dans le pont des paires de tiges.

14. Tige de silicium polycristalline avec un diamètre supérieur ou égal à 130 mm et une longueur supérieure ou égale à 1900 mm, **caractérisée en ce que** celle-ci ne présente aucune fissure ni éclatement sur l'ensemble de sa longueur.

15. Tige de silicium polycristalline selon la revendication 14, avec une longueur supérieure à 2100 mm, laquelle ne présente aucune fissure ni éclatement sur l'ensemble de sa longueur.

16. Utilisation d'une tige de silicium polycristalline selon la revendication 14 ou selon la revendication 15 pour le tirage par zone (procédé de floating-zone).
